# EUROPÄISCHE PATENTSCHRIFT

(11) **EP 1 799 019 B1**
(45) Veröffentlichungstag und Bekanntmachung des Hinweises auf die Patenterteilung: **07.04.2010**
(21) Anmeldenummer: 06024265.8
(22) Anmeldetag: 23.11.2006
(51) Int. Cl.: H05K 1/02, H05K 1/11, B32B 17/10

(54) **Elektrischer Anschluss für einen Sockel**
Electrical connection for a socket
Raccordement électrique pour un socle

(30) Priorität: 15.12.2005 DE 202005020315 U
(43) Veröffentlichungstag der Anmeldung: 20.06.2007
(73) Patentinhaber: Döppner Bauelemente GmbH & Co. KG, 36137 Grossenlüder (DE); Schneider + Fichtel GmbH, 72108 Rottenburg a.N. (DE); Schott AG, 55120 Mainz 1 (DE)
(72) Erfinder: Schneider, Rolf, A., O., 72108 Rottenburg (DE); Döppner, Christoph, 36124 Lütter (DE); Nickut, Andreas, 31073 Delligsen (DE); Albrecht, Bernd, 31073 Delligsen (DE)
(74) Vertreter: Patentanwälte Ruff, Wilhelm, Beier, Dauster & Partner

(56) Entgegenhaltungen:
- EP-A- 1 204 306
- EP-A1- 0 900 971
- WO-A-01/82378
- WO-A-2004/095544
- DE-C1- 19 854 899
- DE-U1- 9 100 936
- GB-A- 1 212 732

## Beschreibung

### Anwendungsgebiet und Stand der Technik

Die Erfindung betrifft einen elektrischen Sockelanschluss an eine vorzugsweise transparente Scheibe, insbesondere einen Sockel für elektrische Leuchtmittel.

Es ist bekannt, Leuchtdioden über transparente elektrisch leitende Schichten auf Glasplatten elektrisch anzuschließen. Die WO 2004/080712A1 und WO 2004/106056A1 beschreiben der Stromzuführungen. Bei ihnen ist die elektrisch leitende Schicht zwischen zwei Scheiben eingeschlossen und die zugehörigen Dioden sind in Ausnehmungen einer der Scheiben zumindest teilweise aufgenommen. Es sind auch Ausführungen bekannt, bei denen auch die Dioden selbst zwischen zwei Scheiben eingeschlossen sind und die Stromzuführung über transpartente Schichten erfolgt.

Es ist ist ferner aus der JP 05-119 706 A und der späteren EP 0 900 971 B1 eine Beleuchtungsvorrichtung bekannt geworden, die als Trägerplatte eine Glasscheibe verwendet, auf der Leiterbahnen als elektrisch leitende dünne und unsichtbare Schicht aufgebracht sind. Die Leuchtmittel sind Leuchtdioden, die unmittelbar auf die Scheibe bzw. die darauf befindlichen Leiterbahnen aufgebracht sind, beispielsweise durch Lötung.

Die WO 01/82378 beschreibt den Gedanken, eine leitfähige Schicht auf einem Träger wie Glas transparent auszubilden und beliebig zu struktur rieren. Dabei können auch LED aufgebracht werden, wobei nicht im Detail beschrieben wird, wie dies erfolgt. Die Darstellung legt jedoch nahe, dass die LED direkt aufgebracht werden, beispielsweise aufgelötet oder aufgeklebt.

Die DE 19854899 zeigt eine weitere Möglichkeit, oberflächenmontierbare Leuchtdioden direkt auf Anschlüsse an einer Trägerplatte aufzulöten.

Die WO 2004/095544 zeigt transparente Elektroden auf einem transparenten Glassubstrat. Aus der Möglichkeit des Vorsehens von Anschlussfeldern oder Kontaktfeldern in Form der Elektroden auf einem Glassubstrat zeigt sie jedoch keine weiteren Vorrichtungen auf dem Glassubstrat.

Die DE 9100936 beschreibt eine Platte mit Leiterbahnen zur Stromversorgung von Leuchtvorrichtungen. Dabei sind jedoch die Elektroanschlüsse durch Niederspannungszuleitungen gebildet bzw. durch massive Kontaktschienen. Die Möglichkeit von transparenten elektrisch leitenden Schichten für einen Elektroanschluss geht daraus nicht hervor.

Die GB 1212732 beschreibt ein transparentes Glassubstrat mit transparenten Schichten darauf. Mittels einer Silberpaste kann eine elektrische Kontaktierung nach außen geführt sein. Es geht daraus jedoch nicht hervor, wie etwas elektrisch oder mechanisch daran angeschlossen werden soll.

Die EP 1204306 beschreibt das Anbringen eines Halbleiterchips auf zwei Kontaktfeldern. Dies erfolgt jedoch unlösbar durch Auflöten des Halbleiterchips selber auf Kontaktfeder. Somit wird hier kein Sockelanschluss oder dergleichen offenbart.

### Aufgabe und Lösung

Aufgabe der Erfindung ist es, einen elektrischen Sockelanschluss zu schaffen, mit dem auf mit einer elektrisch leitenden Schicht versehene Scheiben auch andere Verbraucher, insbesondere Leuchtmittel, aufgebracht werden können.

Gelöst wird diese Aufgabe durch die Merkmale des Anspruchs 1. Gemäß der Erfindung ist die elektrisch leitende Schicht in wenigstens zwei mit unterschiedlichen Polen eines Elektroanschlusses verbundene, durch eine Trennfuge voneinander getrennte Abschnitte unterteilt. Im Bereich der Trennfuge sind auf die elektrisch leitende Schicht zwei ebenfalls elektrisch leitende Felder aufgebracht, beispielsweise durch Siebdruck mit einer Silberleitpaste, an die der Sockel mechanisch und elektrisch angeschlossen ist.

Auf diese Weise lässt sich einerseits eine relativ großflächige Kontaktierung der elektrisch leitenden Schicht erreichen, die daher sehr dünn und somit hochohmig ausgelegt werden kann, ohne dass es zu punktuell hohen Stromdichten kommen kann, auch bei Verwendung von Niederspannung. Ferner ist es möglich, diese Felder in einem vorbereitenden Prozess sowohl elektrisch gut kontaktierend als auch mechanisch fest auf die Scheibe und damit auch die elektrisch leitende Schicht aufzubringen. Der nachfolgende Anschluss des eigentlichen Sockels kann dann mechanisch über Klebung oder ggf. auch durch Lötung oder andere Bindungsmethoden geschehen und der elektrische Anschluss kann in konventioneller Weise durch Lötung oder andere Kontaktierungsmethoden vorgenommen werden, ohne dass damit eine Beeinträchtigung der elektrisch leitenden Beschichtung zu befürchten ist.

Die Felder können als im Bereich der Trennfuge zwischen den beiden elektrisch leitenden Schichtabschnitten als ebenfalls durch eine Trennfuge getrennte geometrische Figuren ausgebildet sein. Besonders eignen sich Halbkreis- oder Halbkreisring-Segmente.

Der Sockel umfasst eine elektrisch nicht leitende Basisplatte, an der eine Fassung eines Leuchtmittels, beispielsweise eine übliche Stecksockel-Keramikfassung für Halogenlampen, befestigt ist. Zur Abdeckung nach außen kann eine an der Basisplatte befestigte Hülse dienen.

Die Erfindung ermöglicht es, außer Leuchtmitteln auch andere elektrische Verbraucher, Sensoren, Regelgeräte und andere auf einen ElektroAnschluss angewiesene Gerätschaften an Scheiben anzubringen, ohne dass sichtbare Zuleitungen erforderlich sind. Dabei kann es sich auch um Lautsprecher, Mikrokameras, Temperatur- oder Bewegungsfühler o. dgl. handeln. Es ist auch möglich, über die elektrisch leitenden Schichten lediglich die Stromversorgung sicherzustellen, während andere Signale, beispielsweise Bildsignale einer Kamera oder Schaltsignale eines Berührungs- oder Annäherungsfühlers, drahtlos übertragen werden. Es wäre auch möglich, die Schicht in drei oder mehr Abschnitte zu unterteilen, die sich unter den entsprechend unterteilten Feldern treffen. Auf diese Weise könnten auch mehr als zwei Anschlüsse zu dem Sockel realisiert werden.

Der elektrische Sockelanschluss nach der Erfindung eignet sich besonders für die Beleuchtung von gläsernen Schaukästen o.dgl.. Wenn beispielsweise ein Sockelanschluss an der oberen Deckscheibe eines solchen Schaukastens hängend angeordnet ist, also innerhalb des Kastens vorgesehen wird, dann kann von dort aus eine wirkungsvolle Beleuchtung für den Inhalt des Schaukastens erfolgen. Dabei ist es möglich, auch Lichtstärke und/oder das Licht bündelnde Leuchtmittel einzusetzen, z.B. Halogen-Reflektorlampen (Spots) oder, um eine Aufheizung des Schaukastens zu vermeiden oder zu verringern, in Form derartiger Reflektorlampen zusammengefasste Mehrfach-Leuchtdioden. Sie ermöglichen eine wesentlich wirkungsvollere und effektivere Beleuchtung der Schauobjekte als es mit Einzeldioden möglich wäre.

Die Stromzuleitung zu den leitenden Schichten, d.h. zu der entsprechenden Scheibe, kann über die Ecken erfolgen. Dort können ebenfalls elektrisch leitende Felder z.B. durch Siebdruck aufgebracht sein, an die dünne Drähte angelötet sind, die in den Stoßkanten der den Schaukasten bildenden Scheiben herunterlaufen und so nahezu unsichtbar sind. Es ist aber auch möglich, einige der Seitenscheiben eines solchen Kastens selbst auch mit elektrisch leitenden Schichten zu versehen und diese in Kontakt mit denen der Scheibe zu bringen, die den Sockelanschluss trägt.

Bei einem solchen Schaukasten besteht noch der Vorteil, dass die elektrisch leitenden Schichten auf der Innenseite sind, so dass sie praktisch vor Berührung oder Beschädigung sicher sind. Es ist jedoch auch möglich, die elektrisch leitende Schicht mit Ausnahme ihrer Kontaktstellen mit einer Versiegelung oder z.B. transparenten Beschichtung zu versehen, um sie zu schützen.

Die vorstehenden und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischenüberschriften beschränkt die unter diesen gemachten Aussagen nicht in ihrer Allgemeingültigkeit.

### Kurzbeschreibung der Zeichnungen

Ein Ausführungsbeispiel der Erfindung ist in der Zeichnung dargestellt und wird im Folgenden näher erläutert. Es zeigen.
- Fig. 1: eine perspektivische Ansicht eines Schaukastens mit dem elektrischen Sockelanschluss an der oberen Deckscheibe und
- Fig. 2: einen Längs-Teilschnitt durch den Sockelanschluss.

### Detaillierte Beschreibung eines Ausführungsbeispiels

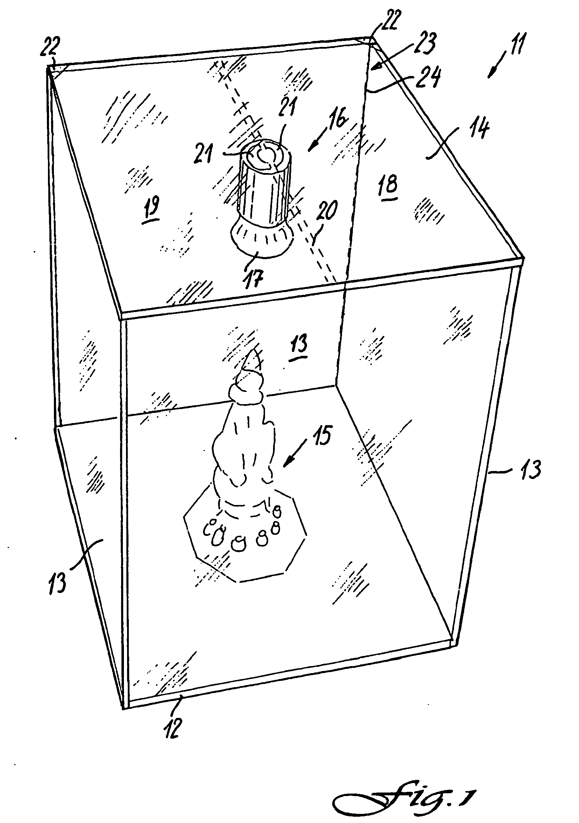

Fig. 1 zeigt einen gläsernen Schaukasten 11, der eine Bodenplatte 12 aus beliebigem Werkstoff, vier Seitenscheiben 13 aus Glas oder einem anderen transparenten Material und eine obere Scheibe 14 aufweist, die an die Seitenscheiben anschließt und den Schaukasten nach oben abschließt. Auf der Bodenplatte des Schaukastens ist ein Ausstellungsobjekt 15 angedeutet.

Die obere Scheibe 14 trägt an ihrer Unterseite mittig, also innerhalb des Schaukastens,einen elektrischen Sockelanschluss 16 für ein Leuchtmittel 17. Der Sockelanschluss ist an der Scheibe 14 ohne sichtbare elektrische Zuleitungen angebracht und scheint daher für den Betrachter über dem Ausstellungsobjekt zu schweben.

Die elektrische Zuleitung zu dem Sockelanschluss erfolgt über eine transparente und daher unsichtbare Schicht an der Unterseite der Scheibe 14. Diese Schicht ist in zwei Abschnitte 18, 19 unterteilt, und zwar durch eine unbeschichtete oder elektrisch isolierende Trennfuge 20. Fig. 1 zeigt, dass diese Trennfuge in der Mitte und auch mittig zum Sockelanschluss geradlienig über die Scheibe verläuft, im gezeigten Beispiel parallel zu zwei der Seitenkanten der Scheibe 14. Sie könnte auch diagonal oder in anderen Richtungen verlaufen. Die Trennfuge kann so schmal sein wie es die Fertigung erlaubt, insbesondere wenn mit elektrischer Niederspannung gearbeitet wird. Gegen Berührung auch von der Innenseite her und z.B. zur Vermeidung von Kurzschlüssen durch Feuchtigkeit (Beschlagen) kann die Schicht mit einer transparenten Versiegelung über Beschichtung versehen sein, außer an den Kontaktstellen.

Die elektrische Kontaktierung des Sockelanschlusses 16 erfolgt im Bereich von Feldern 21, die aus elektrisch leitendem Material bestehen, beispielsweise einer Silberpaste, die durch Siebdruck auf die elektrisch leitenden Abschnitte 18, 19 der Schicht jeweils angrenzend an die Trennfuge 20 aufgebracht und ausgehärtet sind. Sie ermöglichen einen sehr festen und gut kontaktierenden Halt auf der Schicht. Die elektrisch leitende Schicht 18, 19 kann aus verschiedenen bekannten Materialien bestehen und mit den herkömmlichen Verfahren aufgebracht werden. Dies ist beispielsweise in der JP 05-119706 A (veröffentlicht am 18.05.1993) im einzelnen beschrieben. Es kann sich um eine Indium-Zinn-Oxid-Schicht (ITO) handeln, die durch Aufdampfen, Sputtern o.dgl. aufgebracht wurde. Auch die Aufbringung dünner Metallfilme, beispielsweise eines dünnen, durchsichtigen Goldfilms, führt zu hervorragend leitenden Schichten.

Die auf die Schicht 18, 19 aufgebrachten Felder 21 sowie im dargestellten Beispiel an den hinteren Ecken der Scheibe 14 aufgebrachte Felder 22 dienen zum elektrischen Anschluss der Schichten 18, 19 an den Sockelanschluss einerseits und an in den hinteren Stoßkanten 23 zwischen den Seitenscheiben 13 verlegte dünne Anschlussdrähte 24. Durch ihren Verlauf zwischen Glaskanten sind sie einerseits infolge der Reflektion fast unsichtbar und andererseits bedürfen sie keiner elektrischen Isolation.

Die Felder 21, 22 bilden eine recht großflächige Kontaktierung der Schicht-Abschnitte 18, 19, die daher sehr dünn und hochohmig ausgeführt werden kann, ohne dass die Stromdichte an irgendeiner Stelle zu groß werden könnte. Die Felder 21 am Sockelanschluss sind halbkreis- bzw. halbkreisringförmig gestaltet, um sich in die kreisrunde Grundform des Sockels einzufügen und bilden zwischen sich ebenfalls eine Trennfuge.

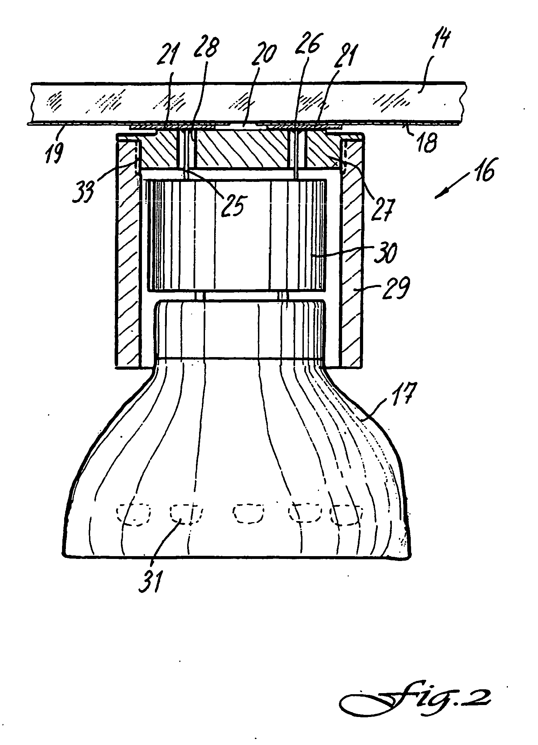

Fig. 2 zeigt den Sockel in Vergrößerung teillängsgeschnitten. Auf der Unterseite der Scheibe 14 sind die beiden Abschnitte 18, 19 der elektrisch leitenden transparenten Schicht zu erkennen, sowie die im Siebdruckverfahren aufgebrachten Felder 21 zu beiden Seiten der Trennfuge 20 zwischen den Schichtabschnitten 18, 19. An diese Schichtabschnitte sind Anschlussdrähte 25 angelötet. Über diese Drähte ist eine Basis 27 geschoben, die aus einem nicht leitenden Material, vorzugsweise Kunststoff, besteht und die Drähte in Durchbrüchen 28 aufnimmt. Die der Scheibe 14 zugekehrte Oberseite der Basisplatte ist mittels eines elektrisch nicht leitfähigen Klebers an die Unterseite der Felder 21 angelötet. Ein gegenüber dieser Klebefläche etwas zurückversetzter Flansch der Basis schafft einen Raum, um überschüssigen Kleber dort hinein zu verdrängen. Am Außenumfang der kreisförmigen Basisplatte 27 ist ein Gewinde 33 vorgesehen, auf das eine Hülse 29 geschraubt werden kann. In dem von der Hülse geschaffenen Raum liegt eine Fassung 30, beispielsweise eine Keramik-Stecksockelfassung, wie sie für Halogenlampen üblich ist. Darin ist das Leuchtmittel 17 eingesteckt, das aus einer Halogenlampe oder, wie hier angedeutet, einer mit einer Vielzahl von Leuchtdioden 31 bestückten Lampe besteht, die ein energiesparendes und wenig Wärme erzeugendes Licht abgibt, das durch den internen Reflektor der Lampe nach Art eines Spot auf das Ausstellungsobjekt 15 gerichtet ist.

Es ist zu erkennen, dass die Erfindung die Möglichkeit schafft, einen Beleuchtungskörper oder ein anderes elektrisches Gerät ohne erkennbare Zuleitungen an oder unter einer durchsichtigen Scheibe, die aus Glas oder anderen transpartenten Materialien bestehen kann, praktisch "schweben" zu lassen. Bei einem Schaukasten, wie er in Fig. 1 dargestellt ist, ist es möglich, das Ausstellungsobjekt praktisch ohne irgendeine Abdeckung oder Sichtbeschneidung von allen Seiten zu betrachten. Die Stromquelle, die bei Niederspannung meist auch einen Transformator umfasst, kann unter der Bodenplatte 12 oder an anderer beliebiger Stelle angebracht werden. Die Anbringung des Sockelanschlusses an der ununterbrochenen Fläche der Scheibe hat den Vorteil der unkomplizierten Herstellung und besseren Optik. Es könnte aber im Sockelbereich auch eine Einsenkung, z.B. eine Einfräsung, vorhanden sein, in die der Sockel hineinragt. Der elektrische Anschluss kann dennoch über die auf die leitende Schicht aufgebrachten Felder erfolgen.

## Patentansprüche

1. Elektrischer Sockelanschluss (16) an eine Scheibe (14), wobei die Scheibe (14) mit einer transparenten, elektrisch leitenden Schicht (18, 19) versehen ist, wobei die elektrisch leitende Schicht in wenigstens zwei mit unterschiedlichen Polen eines Elektroanschlusses verbundene, durch eine Trennfuge (20) voneinander getrennte Abschnitte (18, 19) unterteilt ist und dass im Bereich der Trennfuge (20) auf die elektrisch leitende Schicht mindestens zwei elektrisch leitende Felder (21) aufgebracht sind, an die der Sockelanschluss (16) elektrisch und/oder mechanisch angeschlossen ist, **dadurch gekennzeichnet, dass** der Sockelanschluss (16) eine elektrisch nicht leitende Basis (27), an der eine Fassung für ein Leuchtmittel (17) oder andere elektrische Verbraucher, Sensoren, Regelgeräte befestigt ist, enthält.

2. Sockelanschluss nach Anspruch 1, **dadurch gekennzeichnet, dass** die Felder (21) als Schicht aus elektrisch leitendem Material aufgebracht sind.

3. Sockelanschluss nach Anspruch 1 oder 2, **dadurch gekennzeichnet, dass** die Felder als durch eine Trennfuge getrennte geometrische Figuren, insbesondere als Halbkreis- oder Halbkreisring-Segmente, ausgebildet sind.

4. Sockelanschluss nach einem der vorhergehenden Ansprüche, **dadurch gekennzeichnet, dass** an die Felder (21) Elektroleitungen (25) des Sockelanschlusses (16) angelötet sind.

5. Sockelanschluss nach einem der vorhergehenden Ansprüche, **dadurch gekennzeichnet, dass** der Sockelanschluss (16) an die Felder (21) angeklebt ist.

6. Sockelanschluss nach einem der vorhergehenden Ansprüche, **dadurch gekennzeichnet, dass** der Sockelanschluss (16) eine an der Basis befestigte, die Fassung (30) umgebende Hülse (29) enthält.

7. Sockelanschluss nach einem der vorhergehenden Ansprüche, **dadurch gekennzeichnet, dass** die elektrisch leitenden Schichtabschnitte (18, 19) der Scheibe (14) an wenigstens einer ihrer Kanten oder Ecken mit dem Elektroanschluss kontaktiert sind

8. Sockelanschluss nach Anspruch 7, **dadurch gekennzeichnet, dass** die Kontaktierung an den Elektroanschluss mittels elektrisch leitender, als Schicht aufgebrachter Felder (22) erfolgt.

9. Sockelanschluss nach einem der vorhergehenden Ansprüche, **dadurch gekennzeichnet, dass** die auf ihrer Fläche mit dem Sockelanschluss (16) versehene Scheibe (14) Teil eines aus mehreren durchsichtigen Scheiben (13, 14) bestehenden Kastens (11) ist, wobei der Elektroanschluss in Form von dünnen Drähten (24) in wenigstens einer Stoßfuge (23) zwischen Kanten der Scheiben (13, 14) verläuft oder der Elektroanschluss zu der mit dem Sockelanschluss (16) versehenen Scheibe über ebenfalls elektrisch leitende beschichtete benachbarte Scheiben erfolgt.

10. Sockelanschluss nach einem der vorhergehenden Ansprüche, **dadurch gekennzeichnet, dass** der Sockelanschluss (16) an einer Unterseite einer oberen Scheibe (14) angebracht ist.

11. Sockelanschluss nach einem der vorhergehenden Ansprüche, **dadurch gekennzeichnet, dass** der Sockelanschluss (16) mit einem energiesparenden Leuchtmittel (17), insbesondere einer Ein- oder Mehrfach-Diodenleuchte, versehen ist.

## Claims

1. Electrical base connection (16) on a plate (14), the plate 14 being provided with a transparent, electrically conductive layer (18, 19), wherein the electrically conductive layer is subdivided into at least two sections (18, 19) separated from one another by a separating gap (20) and connected to different poles of an electrical connection and wherein in the vicinity of the gap (20) at least two electrically conductive areas (21) are applied to the electrically conductive layer and to which the base connection (16) is electrically and/or mechanically connected **characterized in that** the electrical base connection (16) comprises an electronically non-conductive basis (27) to which a holder is fixed for a lighting means (17) or other electrical consumers, sensors, regulation units.

2. Base connection according to claim 1, **characterized in that** the areas (21) are applied in the form of a layer of electrically conductive material.

3. Base connection according to claim 1 or 2, **characterized in that** the areas are in the form of geometrical figures separated by a gap, particularly semicircular or semicircular ring segments.

4. Base connection according to one of the preceding claims, **characterized in that** connecting wires (25) of base connection (16) are soldered to areas (21).

5. Base connection according to one of the preceding claims, **characterized in that** the base connection (16) is bonded to the areas (21).

6. Base connection according to one of the preceding claims, **characterized in that** the base connection (16) comprises a sleeve (29) fixed to the base and embracing the holder (30).

7. Base connection according to one of the preceding claims, **characterized in that** the electrically conducting layer sections (18, 19) of plate (14) are contacted with the electrical connection at at least one of their edges or corners.

8. Base connection according to claim 7, **characterized in that** the contacting to the electrical connection takes place by means of electrically conducting areas (22) applied in layer form.

9. Base connection according to one of the preceding claims, **characterized in that** the plate (14) provided on its surface with the base connection (16) is part of a case (11) comprising several transparent plates (13, 14), wherein the electrical connection runs in the form of thin wires (24) in at least one gap (23) between edges of the plates (13, 14) or the electrical connection to the plate provided with the base connection (16) takes place by means of also electrically conducting, coated, adjacent plates.

10. Base connection according to one of the preceding claims, **characterized in that** the base connection (16) is fitted to the underside of an upper plate (14).

11. Base connection according to one of the preceding claims, **characterized in that** the base connection (16) is provided with an energy-saving lighting means (17), particularly a single or multiple diode lighting unit.

## Revendications

1. Raccordement électrique de socle (16) sur une vitre ou une plaque (14), sachant que la vitre (14) est pourvue d'une couche (18, 19) transparente électriquement conductive, sachant que la couche transparente électriquement conductive est subdivisée au moins en deux parties (18, 19) distinctes, qui sont branchées à différents pôles d'une connexion électrique et qui sont séparées par une fente de séparation (20), et sachant que dans la zone de la fente de séparation (20) au moins deux champs électriquement conductifs (21) sont appliqués sur la couche électriquement conductive, auxquels le raccord de socle (16) est connectée de façon électrique et/ou mécanique, **caractérisé en ce que** le raccord de socle (16) comprend une base électriquement non conductive (27), à laquelle est fixé un support pour un agent lumineux (17) ou d'autres dissipateurs, capteurs ou appareils de réglage électriques.

2. Raccordement de socle d'après la revendication 1, **caractérisé en ce que** les champs (21) sont appliqués sous forme de couche en un matériau électriquement conductif.

3. Raccordement de socle d'après la revendication 1 ou 2, **caractérisé en ce que** les champs sont réalisés sous forme de figures géométriques séparées par une fente de séparation, notamment sous forme de segments de demi-cercle ou d'anneaux demi-circulaires.

4. Raccordement de socle d'après une des revendications précédentes, **caractérisé en ce que** des conducteurs électriques (25) du raccord de socle (16) sont soudés aux champs (21).

5. Raccordement de socle d'après une des revendications précédentes, **caractérisé en ce que** le raccord de socle (16) est collé aux champs (21).

6. Raccordement de socle d'après une des revendications précédentes, **caractérisé en ce que** le raccord de socle (16) comprend une douille (29) qui est fixée à la base et qui entoure la prise femelle (30).

7. Raccordement de socle d'après une des revendications précédentes, **caractérisé en ce que** les parties électriquement conductives de la couche (18, 19) de la vitre (14) sont branchées à un raccord électrique au moins dans un de leurs coins ou de leurs arêtes.

8. Raccordement de socle d'après la revendication 7, **caractérisé en ce que** l'établissement du contact avec le raccord électrique est réalisé au moyen de champs (22) électriquement conductifs, appliqués sous forme de couche.

9. Raccordement de socle d'après une des revendications précédentes, **caractérisé en ce que** la vitre (14) munie d'un raccord de socle (16) à sa surface fait partie d'une caisse (11) composée de plusieurs vitres (13, 14) transparentes, sachant que la connexion électrique s'étend sous forme de fils de faible calibre (24) dans au moins un joint (23) entre les arêtes des vitres (13, 14) ou bien que la connexion électrique de la vitre qui porte le raccord de socle (16) est réalisée en passant par des vitres limitrophes qui présentent de même des couches électriquement conductives.

10. Raccordement de socle d'après une des revendications précédentes, **caractérisé en ce que** le raccord de socle (16) est appliqué à la face inférieure d'une plaque supérieure (14).

11. Raccordement de socle d'après une des revendications précédentes, **caractérisé en ce que** le raccord de socle (16) est muni d'un agent lumineux (17) à économie d'énergie, notamment d'un luminaire DEL simple ou multiple.
